Europäisches Patentamt

European Patent Office

Office européen des brevets

(11) Veröffentlichungsnummer : **0 021 217**
**B1**

(12) **EUROPÄISCHE PATENTSCHRIFT**

(45) Veröffentlichungstag der Patentschrift :
**13.07.83**

(21) Anmeldenummer : **80103197.2**

(22) Anmeldetag : **09.06.80**

(51) Int. Cl.³ : **G 11 C 11/24, H 01 L 27/04**

(54) Dynamische Halbleiter-Speicherzelle und Verfahren zu ihrer Herstellung.

(30) Priorität : **29.06.79 DE 2926416**

(43) Veröffentlichungstag der Anmeldung :
**07.01.81 Patentblatt 81/01**

(45) Bekanntmachung des Hinweises auf die Patenterteilung : **13.07.83 Patentblatt 83/28**

(84) Benannte Vertragsstaaten :
**FR GB**

(56) Entgegenhaltungen :
**DE A 2 703 957**
**DE A 2 750 395**
**US A 4 091 405**
**US A 4 115 871**

(73) Patentinhaber : **SIEMENS AKTIENGESELLSCHAFT**
**Berlin und München Wittelsbacherplatz 2**
**D-8000 München 2 (DE)**

(72) Erfinder : **Tihanyi, Jenö, Dr.**
**Wolfratshauser Strasse 179b**
**D-8000 München 71 (DE)** ·

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

Dynamische Halbleiter-Speicherzelle und Verfahren zu ihrer Herstellung

Die Erfindung bezieht sich auf eine dynamische Halbleiter-Speicherzelle nach dem Oberbegriff des Anspruchs 1 und auf Verfahren zu ihrer Herstellung.

Speicherzellen dieser Art sind beispielsweise aus den « Abstracts of the Second European Solid-State Circuits Conference » (ESSCIRC) 21. bis 24. Sept. 1976, Toulouse, Abschn. 4.4, Seiten 40 bis 41, bekannt. Zur Erzielung immer größerer Integrationsdichten strebt man in der Halbleiter-Speichertechnik an, die einzelnen Speicherzellen auf einer möglichst kleinen Halbleiterfläche zu plazieren.

Erfindungsgemäß wird diese Aufgabe durch die im kennzeichnenden Teil des Anspruchs 1 angegebenen Maßnahmen gelöst.

Der mit der Erfindung erzielbare Vorteil besteht insbesondere darin, daß die Zellenstruktur eine wesentlich kleinere Halbleiterfläche für den der Zellenselektion dienenden Transferbereich erfordert, als dies bei den herkömmlichen Speicherzellen dieser Art der Fall ist. Das ist darauf zurückzuführen, daß das Transfergate mit technologisch bedingten Mindestabmessungen ausgeführt werden kann, wobei der von diesem überdeckte Transferkanal eine noch wesentlich kleinere Länge aufweist. Weiterhin ist die auf eine vorgegebene Halbleiterfläche bezogene Kapazität des Speicherkondensators gegenüber den herkömmlichen Speicherzellen wesentlich vergrößert. Die Ansprüche 2 bis 7 sind auf vorteilhafte Ausführungsformen der Erfindung gerichtet, wobei die Ausführungen nach den Ansprüchen 4 und 5 sehr kleine Bitleitungskapazitäten gewährleisten. Besonders günstige Herstellungsverfahren für die erfindungsgemäße Speicherzelle sind in den Ansprüchen 8 bis 12 angegeben.

Aus dem « Technical Digest 1977, International Electron Devices Meeting », 5. bis 7. Dezember 1977, Washington D. C., Seiten 399 bis 401 sind MOS-Feldeffekttransistoren mit sehr kurzen effektiven Kanallängen bekannt, bei denen jeweils ein Gate isoliert auf einer Grenzfläche eines Halbleiterkörpers aufgebracht ist und zwei entgegengesetzt zum Halbleiterkörpers dotierte Gebiete so in diesen eingefügt sind, daß sie beiderseits des Gate an der Grenzfläche des Halbleiterkörpers liegen. Unterhalb eines dieser Gebiete (Sourcegebiet) ist eine weitere Halbleiterzone vorgesehen, die parallel zur Grenzfläche verläuft und einen höheren Dotierungsgrad als der Halbleiterkörper aufweist, aber denselben Leitungstyp wie dieser besitzt. Ein unterhalb des Gate liegender Randbereich der weiteren Halbleiterzone erstreckt sich bis zur Grenzfläche hin, so daß er dieses eine Gebiet (Sourcegebiet) in lateraler Richtung begrenzt. Weiterhin ist unterhalb des Gate ein der Grenzfläche benachbarter, den Randbereich der weiteren Halbleiterzone mit dem anderen Gebiet verbindender Bereich des Halbleiterkörpers vorgesehen, der zu diesem entgegengesetzt dotiert ist. Der an der Grenzfläche liegende Teil des Randbereiches bildet einen einteiligen Kanalbereich des Transistors. Diese Veröffentlichung bezieht sich jedoch nicht auf Auswahlelemente für Halbleiter-Speicherzellen.

Die gleichzeitig eingereichte europäische Patentanmeldung 80 103 198.0 (Veröffentlichungsnummer 0 021 218) bezieht sich auf eine dynamische Halbleiterspeicherzelle mit einem Feldeffekttransistor, der ein isoliert auf der Grenzfläche eines Halbleiterkörpers aufgebrachtes Gate und zwei bezüglich einer Grunddotierung des Halbleiterkörpers entgegengesetzt dotierte Gebiete aufweist, und mit einem Speicherkondensator, der eine ebenfalls entgegengesetzt dotierte, der Grenzfläche benachbarte erste Zone des Halbleiterkörpers und eine isoliert auf der Grenzfläche aufgebrachte Elektrode aufweist, bei der das eine Gebiet mit einer Bitleitung und das andere mit der ersten Zone verbunden ist. Hierbei handelt es sich also um eine Ein-Transistor-Speicherzelle.

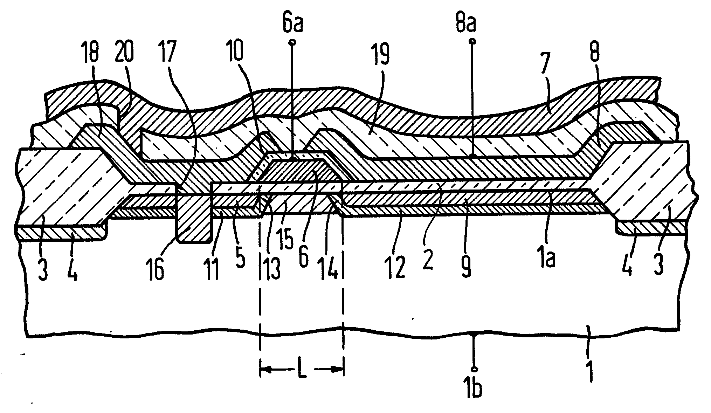

In der Zeichnung ist ein Querschnitt durch eine nach der Erfindung ausgebildete Halbleiter-Speicherzelle dargestellt. Dabei ist ein Halbleiterkörper, z. B. aus p-dotiertem Silizium, mit 1 bezeichnet. Seine Grenzfläche 1a ist mit einer elektrisch isolierenden Schicht bedeckt, die einen Bereich 2 mit kleinerer Schichtdicke aufweist. An den Bereich 2 schließen sich Bereiche 3 der elektrisch isolierenden Schicht an, die mit einer wesentlich größeren Schichtdicke ausgeführt sind. Für den Fall, daß die isolierende Schicht aus $SiO_2$ besteht, werden die Bereiche 2 und 3 auch als Gateoxid- und Feldoxidschichten bezeichnet. Unterhalb der Feldoxidschichten 3 sind Halbleiterbereiche 4 vorgesehen, die mit $p^+$-Feldimplantation versehen sind und den Bereich der Speicherzelle zwischen sich einschließen.

Ein der Grenzfläche 1a benachbartes, $n^+$-dotiertes Gebiet 5 bildet zusammen mit einem auf der Gateoxidschicht 2 angeordneten Transfergate 6 ein die Zellenselektion durchführendes Auswahlelement. Dabei ist das $n^+$-Gebiet 5 in einer noch näher zu beschreibenden Weise mit einer Bitleitung 7 verbunden, über die eine zu speichernde binäre Information in die Speicherzelle eingeschrieben bzw. aus ihr ausgelesen wird. Neben dem Transfergate 6 ist eine Elektrode 8 auf der Gateoxidschicht 2 angeordnet, die einen Bestandteil des Speicherkondensators darstellt. Unterhalb der Elektrode 8 befindet sich eine der Grenzfläche 1a benachbarte Zone 9 des Halbleiterkörpers, die zu seiner p-Grunddotierung entgegengesetzt dotiert ist, d. h. im vorliegenden Fall eine $n^+$-Dotierung aufweist. Die Elektrode 8 überdeckt dabei randseitig das Transfergate 6, wobei sich zwischen diesen Teilen eine zweite elektrisch isolierende Schicht 10, z. B. aus $SiO_2$, befindet, die das Transfergate 6 vollständig abdeckt. Das Transfergate 6 ist mit einer Wortleitung verbunden, über die die Speicherzelle selektiert werden kann, während die Elektrode 8 mit einer festen Spannung beschaltet ist. Insbesondere bestehen das Transfergate 6 und die Elektrode 8 aus Teilen von streifenförmig ausgebildeten, senkrecht zur Bildebene verlaufenden, elektrisch leitenden Belegungen, die einer Gruppe von hintereinander liegenden Speicherzellen gemeinsam sind. Die das Gate 6 enthaltende Belegung stellt dann gleichzeitig eine diesen Speicherelementen gemeinsame Wortleitung dar, während die die Elektrode 8 enthaltene Belegung als eine diesen Speicherzellen gemeinsame Kondensatorleitung bezeichnet wird. Mit besonderem Vorteil sind das Transfergate 6 und die Elektrode 8 aus hochdotiertem, polykristallinen Silizium gebildet.

Unterhalb des Gebietes 5 und der Zone 9 befinden sich bezüglich der Grunddotierung des Halbleiterkörpers 1 gleichsinnig dotierte, jedoch einen höheren Dotierungsgrad aufweisende, d. h. $p^+$-dotierte Zonen 11 und 12. Unterhalb des Transfergate 6 liegende Randbereiche 13, 14 dieser Zonen erstrecken sich bis zur Grenzfläche 1a hin, so daß sie das Gebiet 5 und die Zone 9 in lateraler Richtung begrenzen. Unterhalb des Transfergate 6 befindet sich ferner ein der Grenzfläche 1a benachbarter, die Randbereiche 13 und 14 miteinander verbindender, schwach n-dotierter Bereich 15. Legt man an das Transfergate 6 über einen Anschluß 6a eine die Einsatzspannung der MIS-Strukturen 6, 2, 13 bzw. 6, 2, 14 übersteigende Spannung an, so bilden sich an den der Grenzfläche 1a anliegenden Teilen der Randbereiche 13 und 14 jeweils Inversionsschichten aus, die eine leitende Verbindung zwischen dem Gebiet 5 und dem Bereich 15 sowie zwischen diesem und der Zone 9 herstellen. Die der Grenzfläche 1a benachbarten Teile der Bereiche 13 und 14 stellen somit jeweils Teile eines Transferkanals dar, die durch den Bereich 15 miteinander verbunden sind.

Mit dem Gebiet 5 ist ein zusätzliches n-dotiertes Gebiet 16 verbunden, das sich bis zur Grenzfläche 1a hin erstreckt. Die Gateoxidschicht 2 weist im Bereich des zusätzlichen Gebietes 16 ein Kontaktloch 17 auf, in dem eine elektrisch leitende Belegung 18, die teilweise oberhalb der Feldoxidschicht 3 angeordnet ist, das Gebiet 16 kontaktiert. Eine die Teile 8 und 18 abdeckende, weitere Isolierschicht 19, die vorzugsweise ebenfalls aus $SiO_2$ besteht, weist oberhalb der Belegung 18 ein Kontaktloch 20 auf, in dem eine als metallische Leiterbahn ausgeführte, auf der Isolierschicht 19 verlegte Bitleitung 7 die Belegung 18 ihrerseits kontaktiert.

Das Transfergate 6 wird zweckmäßigerweise so ausgeführt, daß es eine Länge L besitzt, die einem technologisch bedingten Mindestmaß von beispielsweise 1 bis 2 µm entspricht. Jeder innerhalb der Randgebiete 13 und 14 liegende Teil des Transferkanals weist dann eine Länge auf, die nur einem Bruchteil dieses Maßes entspricht, also z. B. 0,2 bis 0,3 µm. Derartige laterale Abmessungen bringen es mit sich, daß der für die Zellenselektion erforderliche Bedarf an Halbleiterfläche extrem klein gehalten werden kann. Andererseits wird hierdurch auch eine weitgehende Unabhängigkeit der Einsatzspannung der MIS-Strukturen 6, 2, 13 und 6, 2, 14 von Schwankungen einer über einen Anschluß 1b angelegten, negativen Vorspannung des Halbleiterkörpers 1 erreicht. An der Grenzfläche zwischen der Zone 9 und der weiteren Zone 12 besteht eine Sperrschichtkapazität, die dem aus den Teilen 8 und 9 gebildeten Speicherkondensator parallel geschaltet ist und somit die Speicherkapazität der Zelle vergrößert.

Im Betrieb wird zum Einschreiben einer binären Information in die Speicherzelle so vorgegangen, daß das Transfergate 6 bzw. die mit diesem verbundene Wortleitung über den Anschluß 6a mit einer über der Einsatzspannung der MIS-Strukturen 6, 2, 13 und 6, 2, 14 liegenden Gatespannung beschaltet wird. Dadurch invertieren die an der Grenzfläche 1a liegenden Teile der Randbereiche 13, und 14, so daß zwei durch den Bereich 15 miteinander verbundene, n-leitende Transferkanalteile entstehen. Dies ergibt eine leitende Verbindung zwischen dem mit der Bitleitung 7 in Verbindung stehenden Gebiet 5 und der Zone 9. Je nach der einzuschreibenden binären Information liegt die Bitleitung 7 auf einem niedrigen oder hohen positiven Potential, während die Elektrode 8 über einen Anschluß 8a an ein konstantes positives Potential gelegt ist. Bei einer auf niedrigem Potential liegenden Bitleitung 7 gelangen dann Ladungsträger aus dem Gebiet 5 in den aus den Teilen 8, 9 sowie 9, 12 gebildeten Speicherkondensator und laden diesen entsprechend auf. Legt man dann beim Auslesen der gespeicherten Information ein hohes Potential an die Bitleitung 7 und schaltet diese dann von äußeren Potentialen frei, d. h. bringt sie in einen Zustand, der mit « floating » bezeichnet wird, so fließt die Ladung bei leitendem Transferkanal 13, 14 wieder zurück und erzeugt einen Potentialabfall auf der Bitleitung, der von einer an diese angeschlossenen Leseeinrichtung ausgewertet wird. Das Auslesesignal ist um so größer, je kleiner die Kapazität der Bitleitung 7 gegenüber dem an die Vorspannung gelegten Halbleiterkörper 1 ist. Die in der Zeichnung gezeigte Ausführung der Speicherzelle, bei der die Bitleitung 7 über die leitende Belegung 18 und das zusätzliche Gebiet 16 mit dem Gebiet 5 verbunden ist, weist eine besonders kleine Bitleitungskapazität auf.

Nach einer anderen Ausführungsform der Erfindung kann das zusätzliche Gebiet 16 einen Teil eines streifenförmigen Halbleitergebietes darstellen, das gleichzeitig die Bitleitung bildet. In diesem Fall kann die Leitung 7 als Wortleitung angesehen werden, die dann in einem nicht dargestellten Kontaktloch der isolierenden Schicht 19 das Transfergate 6 kontaktiert. Bei dieser Ausführungsform ist jedoch die Bitleitungskapazität größer als bei der dargestellten, so daß das Auslesesignal der Speicherzelle kleiner ist.

Bei einer weiteren Ausführungsform kann die leitende Belegung 18, die das zusätzliche Gebiet 16 kontaktiert, aus einem Teil einer streifenförmigen, leitenden Belegung bestehen, die selbst als Bitleitung dient. Eine solche Ausführungsform liegt dann sowohl bezüglich des strukturellen Aufwands als auch bezüglich der Größe des Auslesesignals zwischen den ersten beiden Ausführungsformen.

Bei der Herstellung der erfindungsgemäßen Speicherzelle wird vorzugsweise so vorgegangen, daß zunächst der p-dotierte Halbleiterkörper 1 an seiner Grenzfläche 1a mit einem den Zellenbereich einschließenden $p^+$-dotierten Gebiet 4 versehen wird. Die Grenzfläche 1a wird außerdem mit einer elektrisch isolierenden Schicht abgedeckt, die außerhalb des Zellenbereiches zu Feldoxidbereichen 3 anwächst, während sie innerhalb des Zellenbereiches einen Gateoxidbereich 2 bildet. Weiterhin wird eine der Grenzschicht 1a anliegende, n-leitende Dotierungszone vorgesehen, von der in der Zeichnung nur der mit 15 bezeichnete Teile sichtbar ist. Es folgt ein Maskierungsschritt, der die Lage des zusätzlichen n-leitenden Gebietes 16 definiert und ein dieses Gebiet erzeugender Diffusions- oder Implantationsvorgang. Anschließend wird die isolierende Schicht 2, 3 mit einer Schicht aus hochdotiertem polykristallinen Silizium belegt. Aus dieser letzteren Schicht wird mit Hilfe an sich bekannter fotolithografischer Schritte das Transfergate 6 gebildet. Dabei wird zum Entfernen der überflüssigen Schichtteile vorzugsweise ein Plasmaätzverfahren verwendet, um an dem bestehenbleibenden Transfergate abgeschrägte Kanten zu erhalten, wie das in den « Proc. of the International Conference on Microlithography », Paris 1977, S. 339 bis 342 beschrieben ist.

Mittels einer ersten Ionenimplantation werden nun Ionen eines eine positive Leitfähigkeit bewirkenden Dotierungsstoffes mit einer solchen Energie eingebracht, daß in den Halbleiterbereichen, die lediglich von der Gateoxidschicht 2 bedeckt sind, tiefliegende, $p^+$-dotierte Gebiete 11 und 12 entstehen. Die abgeschrägten Kanten des Transfergate 6 bewirken dabei, daß unter ihnen Randbereiche 13 und 14 dieser Gebiete entstehen, die bis an die Grenzfläche 1a reichen. Es schließt sich eine zweite Ionenimplantation an, bei der Ionen von Dotierungsstoffen, die eine negative Leitfähigkeit im Halbleiterkörper 1 hervorrufen, eingebracht werden. Hierbei wird jedoch eine geringere Beschleunigungsenergie aufgewandt, so daß das an der Grenzfläche 1a liegende $n^+$-dotierte Gebiet 5 und die Zone 9 entstehen. Die von dem Transfergate 6 bedeckten Teile des Halbleiterkörpers 1 werden von den genannten Ionenimplantationen nicht beeinflußt, wenn man von den abgeschrägten Randzonen des Gate 6 absieht.

In einem weiteren Verfahrensschritt wird das Transfergate 6 mit einer zweiten elektrisch isolierenden Schicht 10 bedeckt, die auch Teile der Gateoxidschicht 2 ersetzen kann. Oberhalb des Gebietes 16 wird eine Öffnung 17 in der Isolierschicht 2 bzw. 10 vorgesehen. Auf der Schicht 10 und den von ihr nicht ersetzten Teilen der Gateoxidschicht 2 wird sodann eine zweite Schicht aus hochdotiertem, polykristallinem Silizium aufgebracht, aus der mittels fotolithografischer Verfahrensschritte die Strukturen 8 und 18 gebildet werden. Dabei stellt die Struktur 18 eine das Gebiet 16 kontaktierende Belegung dar, während die Struktur 8 die eine Elektrode des Speicherkondensators bildet. Es folgt eine Belegung der nach den bisherigen Verfahrensschritten erhaltenen Teilstruktur mit einer elektrisch isolierenden Schicht 19, auf der nach dem Anbringen eines Kontaktloches 20 die Bitleitung 7 verlegt wird, die z. B. aus einer Aluminiumbahn besteht.

Nach einer ersten Alternative des Herstellungsverfahrens entfällt das Aufbringen der leitenden Belegung 18. Stattdessen wird eine mit dem Gebiet 16 verbundene, zu der Grunddotierung des Halbleiterkörpers 1 entgegengesetzt dotierte, streifenförmige Halbleiterzone erzeugt, die als Bitleitung dient. Eine zweite Alternative besteht darin, daß die leitende Belegung 18 streifenförmig ausgebildet wird, wobei sie mehreren in einer Reihe angeordneten Speicherzellen gemeinsam zugeordnet ist und eine diesen gemeinsame Bitleitung bildet.

Zur weiteren Erläuterung der Erfindung kann das folgende Dotierungsbeispiel dienen, bei dem von einem mit $10^{14}$ bis $10^{15}$ cm$^{-3}$ Akzeptoren, z. B. Bor-Atomen, dotierten Siliziumkörper 1 ausgegangen wird. Die Gebiete 4 weisen eine Dosis von 5 bis 10 · $10^{11}$ cm$^{-2}$ Akzeptoren auf, der Bereich 15 eine solche von $10^{12}$ cm$^{-2}$ Donatoren, z. B. Phosphor-Atomen. Die Dotierung des Gebietes 16 beträgt etwa $10^{20}$ cm$^{-3}$ Donatoren, z. B. Arsen-Atome, während sich die Dosis des Gebietes 5 und der Zone 9 auf etwa $10^{15}$ cm$^{-2}$ Donatoren, z. B. Arsen-Atome, beläuft. Die Zonen 11, 13 und 12, 14 sind mit einer Dosis von 2 bis 3 · $10^{12}$ cm$^{-2}$ Akzeptoren, z. B. Bor-Atomen, dotiert. Zum Implantieren der die Zonen 11, 13 und 12, 14 erzeugenden Akzeptorionen wird eine Beschleunigungsenergie von etwa 150 kEV verwendet, zum Einbringen der das Gebiet 5 und die Zone 9 erzeugenden Donatorionen eine solche von etwa 100 kEV. Leztere Angaben beziehen sich auf ein Ausführungsbeispiel, bei dem das Gebiet 5 und die Zone 9 jeweils eine senkrecht zur Grenzfläche 1a gemessene Dicke von 0,2 µm aufweisen, während die Zonen 11 und 12 mit einer Dicke von 0,3 µm ausgeführt sind. Was die weiteren Strukturabmessungen anbetrifft, so beträgt die Dicke der Teile 6, 8 und 18 etwa 0,4 bis 0,7 µm und die Dicke der Schicht 2 etwa 50 nm. Die isolierende Schicht 19 weist eine Dicke von etwa 1 bis 2 µm auf.

Andere vorteilhafte Verfahren zur Herstellung der erfindungsgemäßen Speicherzelle unterscheiden sich von den oben beschriebenen dadurch, daß das Gebiet 5 und die Zonen 9 sowie 11 bis 14 nicht durch Implantationsschritte, sondern durch Diffusionsschritte erzeugt werden. Hierbei können die Kanten des Transfergate 6 auch in vertikaler Richtung verlaufen. Eine erste Diffusion von Akzeptor-Atomen erzeugt die Zonen 11 bis 14, während eine nachfolgende Diffusion mit Donator-Atomen das Gebiet 5 und die Zone 9 erzeugt. Die Dicke der Zonen 11 bis 14 wird durch unterschiedliche Diffusionszeiten bei beiden Diffusionsvorgängen eingestellt, was an sich aus der DMOS-Technologie bekannt ist.

Die Speicherzelle nach der Erfindung kann selbstverständlich auch auf einem n-dotierten Siliziumkörper 1 aufgebaut werden, wobei die Dotierungen derart abgeändert werden, daß sich jeweils die entgegengesetzten Leitfähigkeiten zu den bisher beschriebenen ergeben. In diesem Fall werden der Bitleitung 7 und den Anschlüssen 6a und 8a negative Spannungen zugeführt, während an dem Anschluß 1b zweckmäßigerweise eine positive Vorspannung liegt.

**Ansprüche**

1. Dynamische Halbleiter-Speicherzelle mit einem Speicherkondensator, der eine isoliert auf der Grenzfläche eines Halbleiterkörpers aufgebrachte Elektrode aufweist, mit einem mit einer Bitleitung verbundenen Gebiet, das entgegengesetzt zu dem Halbleiterkörper dotiert ist und mit einem mit einer Wortleitung verbundenen Transfergate, das isoliert auf einem Teil der Grenzfläche aufgebracht ist, wobei dieser Teil an das genannte Gebiet und an den von der Elektrode überdeckten Halbleiterbereich des Speicherkondensators unmittelbar angrenzt, dadurch gekennzeichnet, daß unterhalb der Elektrode (8) eine ebenfalls entgegengesetzt dotierte, der Grenzfläche (1a) benachbarte erste Zone (9) des Halbleiterkörpers (1) vorgesehen ist, daß im wesentlichen parallel zu der Grenzfläche (1a) verlaufende, bezüglich der Grunddotierung gleichsinnig dotierte, jedoch einen höheren Dotierungsgrad aufweisende, weitere Zonen (11, 12) vorgesehen sind, die unterhalb des genannten Gebietes (5) und der ersten Zone (9) liegen, daß sich unterhalb des Transfergate (6) liegende Randbereiche (13, 14) der weiteren Zonen (11, 12) bis zur Grenzfläche (1a) hin erstrekken, so daß sie das Gebiet (5) und die erste Zone (9) in lateraler Richtung begrenzen, daß unterhalb des Transfergate (6) ein der Grenzfläche (1a) benachbarter, die genannten Randbereiche (13, 14) verbindender Bereich (15) des Halbleiterkörpers (1) mit einer zu der Grunddotierung entgegengesetzten Dotierung versehen ist und daß die an der Grenzfläche (1a) liegenden Teile der Randbereiche (13, 14) einen zweiteiligen Transferkanal zwischen dem Gebiet (5) und der ersten angrenzenden Zone (9) bilden.

2. Halbleiter-Speicherzelle nach Anspruch 1, dadurch gekennzeichnet, daß das mit der Bitleitung verbundene Gebiet mit einem zusätzlichen, bezüglich der Grunddotierung entgegengesetzt dotierten Gebiet (16) verbunden ist.

3. Halbleiter-Speicherzelle nach Anspruch 2, dadurch gekennzeichnet, daß das zusätzliche, entgegengesetzt dotierte Gebiet (16) mit einer in dem Halbleiterkörper (1) vorgesehenen, entgegengesetzt dotierten, streifenförmigen Halbleiterzone verbunden ist, die als Bitleitung dient.

4. Halbleiter-Speicherzelle nach Anspruch 2, dadurch gekennzeichnet, daß das zusätzliche, entgegengesetzt dotierte Halbleitergebiet (16) im Bereich eines Kontaktloches (17) der ersten elektrisch isolierenden Schicht (2) mit einer elektrisch leitenden Belegung (18) kontaktiert ist, die ihrerseits mit einer Bitleitung verbunden ist.

5. Halbleiter-Speicherzelle nach Anspruch 4, dadurch gekennzeichnet, daß die Bitleitung als eine metallische Leiterbahn (7) ausgeführt ist, die auf einer die elektrisch leitende Belegung (18) abdeckenden Isolierschicht (19) verlegt ist und im Bereich eines weiteren Kontaktloches (20) die elektrisch leitende Belegung (18) kontaktiert.

6. Halbleiter-Speicherzelle nach einem der vorhergehenden Ansprüche, dadurch gekennzeichnet, daß der Halbleiterkörper (1) mit einem an einer festen Spannung liegenden Anschluß (1b) versehen ist und daß die Elektrode (8) des Speicherkondensators über einen Anschluß (8a) mit einer konstanten Spannung beschaltet ist.

7. Halbleiter-Speicherzelle nach einem der vorhergehenden Ansprüche, dadurch gekennzeichnet, daß der Halbleiterkörper (1) aus dotierten Silizium besteht und daß das Transfergate (6) und/oder die Elektrode (8) des Speicherkondensators und/oder die das zusätzliche Gebiet (16) kontaktierende Belegung (18) aus hochdotiertem, polykristallinen Silizium gebildet sind.

8. Verfahren zur Herstellung einer Halbleiter-Speicherzelle nach Anspruch 1, dadurch gekennzeichnet, daß ein mit einer Grunddotierung versehener Halbleiterkörper (1) mit einer seiner Grenzfläche (1a) benachbarten Dotierungszone (15) versehen wird, die eine zu der Grunddotierung entgegengesetzte Dotierung aufweist, daß die Grenzfläche (1a) mit einer ersten elektrisch isolierenden Schicht abgedeckt wird, die einen oberhalb der Dotierungszone liegenden Dünnschichtbereich (2) und einen diesen umgebenden Dickschichtbereich (3) aufweist, daß das Transfergate (6) auf der ersten elektrisch isolierenden Schicht (2, 3) plaziert wird, daß eine erste Maske vorgesehen wird, die das Transfergate (6), das mit der Bitleitung verbundene Gebiet (5) und den Bereich des Speicherkondensators unbedeckt läßt, daß ein erster Dotierungsschritt mit einem der Grunddotierung entsprechenden Dotierstoff vorgenommen wird, der die unterhalb des genannten Gebietes (5) und der ersten Zone (9) liegenden weiteren Zonen erzeugt, daß ein zweiter Dotierungsschritt mit einem Dotierstoff erfolgt, der eine zu der Grunddotierung entgegengesetzte Dotierung erzeugt und das mit der Bitleitung verbundene Gebiet (5) und die genannte erste Zone (9) bildet, wobei diese beiden Dotierungsschritte derart aufeinander abgestimmt sind, daß unterhalb des Transfergate (6) Randbereiche der weiteren Zonen entstehen, die sich bis zur Grenzfläche (1a) hin erstrecken und das genannte Gebiet (5) und die erste Zone (9) in lateraler Richtung begrenzen, daß nach dem Entfernen der ersten Maske das Transfergate (6) mit einer zweiten elektrisch isolierenden Schicht (10) bedeckt wird und daß die Elektrode (8) des Speicherkondensators auf der zweiten (10) und den von dieser nicht ersetzten Teilen der ersten elektrisch isolierenden Schicht (2) plaziert wird, so daß sie das Transfergate (6) randseitig überlappt.

9. Verfahren nach Anspruch 8 zur Herstellung einer Halbleiter-Speicherzelle nach Anspruch 2, dadurch gekennzeichnet, daß das zusätzliche, entgegengesetzt dotierte Gebiet (16) mittels fotolithografischer Schritte definiert und derart an der Grenzfläche (1a) des Halbleiterkörpers (1) vorgesehen wird, daß es mit dem mit der Bitleitung verbundenen Gebiet (5) verbunden ist.

10. Verfahren nach Anspruch 9, dadurch gekennzeichnet, daß außer der Elektrode (8) auch eine das zusätzliche Gebiet (16) kontaktierende, leitende Belegung (18) auf der zweiten (10) und den von dieser nicht ersetzten Teilen der ersten elektrisch isolierenden Schicht (2) plaziert wird, daß die kontaktierende Belegung (18) mit einer weiteren, elektrisch isolierenden Schicht (19) abgedeckt wird und daß auf der letzteren eine Leiterbahn (7) verlegt wird, die die kontaktierende Belegung (18) innerhalb eines in der weiteren elektrisch isolierenden Schicht (19) vorgesehenen Kontaktloches (20) ihrerseits kontaktiert.

11. Verfahren nach Anspruch 8, dadurch gekennzeichnet, daß das Transfergate (6) mit abgeschrägten Kanten ausgebildet wird und daß die beiden Dotierungsschritte aus Ionenimplantationsschritten bestehen.

12. Verfahren nach Anspruch 8, dadurch gekennzeichnet, daß die beiden Dotierungsschritte aus Diffusionsschritten bestehen.

**Claims**

1. A dynamic semiconductor storage cell having a storage capacitor provided with an electrode applied in insulated fashion to the boundary surface of a semiconductor body, a region which is connected to a bit line and is oppositely-doped to the semiconductor body, and a transfer gate which is connected to a word line and is applied in insulated fashion to a part of the boundary surface, said part directly adjoining said region and the semiconductor zone of the storage capacitor, which is covered by the electrode, characterised in that, below the electrode (8), there is arranged a similarly oppositely-doped first zone (9) of the semiconductor body (1) adjoining the boundary surface (1a) ; that further zones (11, 12) are provided, which essentially run parallel to the boundary surface (1a), which are similarly doped as regards the basic doping, but have a higher doping level, and which lie beneath said region (5) and the first zone (9) ; that edge regions (13, 14) of the further zones (11, 12) lying beneath the transfer gate (6) extend to the boundary surface (1a), so that they laterally delimit the region (5) and the first zone (9) ; that beneath the transfer gate (6), a region (15) of the semiconductor body is provided adjacent to the boundary surface (1a), and which connects said edge regions (13, 14), and has a doping which is opposite to the basic doping ; and that the parts of the edge regions (13, 14) which lie in the boundary surface (1a) form a two-part transfer channel between the region (5) and the adjoining first zone (9).

2. A semiconductor storage cell as claimed in Claim 1, characterised in that the region connected to the bit line is connected to an additional zone (16) which is oppositely-doped with respect to the basic doping.

3. A semiconductor storage cell as claimed in Claim 2, characterised in that the additional, oppositely-doped zone (16) is connected to an oppositely-doped, strip-shaped semiconductor zone which is provided in the semiconductor body (1) and serves as a bit line.

4. A semiconductor storage cell as claimed in Claim 2, characterised in that, the additional, oppositely-doped semiconductor zone (16) is contacted in the region of a contact hole (17) in the first electrically-insulated layer (2), with an electrically-conductive coating (18), which in turn is connected to a bit line.

5. A semiconductor storage cell as claimed in Claim 4, characterised in that the bit line is constructed as a metal conductor path (7) which runs on an insulating layer (19) covering the electrically-conductive coating (18), and which contacts the electrically-conductive coating (18) in the region of a further contact hole (20).

6. A semiconductor storage cell as claimed in one of the preceding Claims, characterised in that the semiconductor body (1) is provided with a terminal (1b) which is connected to a fixed voltage, and that the electrode (8) of the storage capacitor is connected by way of a terminal (8a) to a constant voltage.

7. A semiconductor storage cell as claimed in one of the preceding Claims, characterised in that the semiconductor body (1) consists of doped silicon and that the transfer gate (6) and/or the electrode (8) of the storage capacitor and/or the coating (18) contacting the additional zone (16) is or are formed of highly-doped polycrystalline silicon.

8. A process for the production of a semiconductor storage cell as claimed in Claim 1, characterised in that a semiconductor body (1) having a basic doping, is provided with a doped zone (15) which is adjacent to its boundary surface (1a) and which has a doping which is opposite to the basic doping ; that the boundary surface (1a) is covered with a first electrically-insulating layer which has a thin region (2) arranged above the doped zone and a thick region (3) surrounding the thin region ; that the transfer gate (6) is placed on the first electrically-insulating layer (2, 3) ; that there is provided a first mask which leaves uncovered the transfer gate (6), the region (5) connected to the bit line, and the region of the storage capacitor ; that a first doping step using a dopant corresponding to the basic doping is carried out, which step produces the further zones which lie beneath said region (5) and the first zone (9) ; that a second doping step is carried out using a dopant which produces a doping opposite to the basic doping to form the region (5) connected to the bit line and said first zone (9), the two doping steps being so adjusted relative to one another that below the transfer gate (6), edge regions of the further zones are produced which extend to the boundary surface (1a) and laterally delimit said region (5) and the first zone (9) ; that, after removal of the first mask, the transfer gate (6) is covered with a second electrically-insulating layer (10) ; and that the electrode (8) of the storage capacitor is placed on the second layer (10) and the parts of the first electrically-insulating layer (2) which have not been replaced by the second layer (1), so that it peripherally overlaps the transfer gate (6).

9. A process as claimed in Claim 8 for the production of a semiconductor storage cell as claimed in Claim 2, characterised in that the additional, oppositely-doped zone (16) is defined by means of photolithographic steps and is arranged in the boundary surface (1a) of the semiconductor body (1) in such manner that it is connected to the region (5) which is connected to the bit line.

10. A process as claimed in Claim 9, characterised in that, in addition to the electrode (8), a conductive coating (18) which contacts the additional zone (16) is placed on the second layer (10) and the parts of the first electrically-insulating layer (2) which are not replaced by the second layer (10) ; that the contacting coating (18) is covered with a further, electrically-insulating layer (19) ; and that on the latter, there is laid a conductor path (7) which in turn contacts the contacting coating (18) within a contact hole (20) which is provided in the further electrically-insulating layer (19).

11. A process as claimed in Claim 8, characterised in that the transfer gate (6) is provided with chamfered edges ; and that the two doping steps are ion implantation steps.

12. A process as claimed in Claim 8, characterised in that the two doping steps are diffusion steps.

**Revendications**

1. Cellule de mémoire dynamique à semiconducteurs qui comporte un condensateur de mémorisation, qui comprend une électrode disposée de façon isolée sur la surface limite d'un corps semiconducteur, une région couplée à une ligne de bits, qui présente un dopage opposé à celui du corps semiconducteur, et une porte de transfert, reliée à une ligne de mots, qui est disposée de façon isolée sur une partie de la surface limite, cette partie se raccordant directement à ladite région et au domaine semiconducteur du condensateur de mémorisation qui est recouvert par l'électrode, caractérisée par le fait qu'une première zone (9) du corps semiconducteur (1), voisine de la surface limite (1a) et également dopée de façon opposée, est prévue sous l'électrode (8), que sont prévues d'autres zones (11, 12) qui s'étendent sensiblement parallèlement à la surface limite (1a), qui présentent le même dopage que le dopage de base mais un degré de dopage plus élevé, et qui se trouvent sous ladite région (5) et la première zone (9), que des domaines marginaux (13, 14), se trouvant sous la porte de transfert (6), des autres zones (11, 12) s'étendent jusqu'à la surface limite (1a), de sorte qu'ils délimitent la région (5) et la première zone (9) dans la direction latérale, que sous la porte de transfert (6) est prévue une région (15) du corps semiconducteur (1), voisine de la surface limite (1a) et reliant lesdits domaines marginaux (13, 14), et qui possède un dopage opposé au dopage de base, et que les parties des domaines marginaux (13, 14), qui se trouvent au niveau de la surface limite (1a), forment un canal de transfert en deux parties entre la région (5) et la première zone voisine (9).

2. Cellule de mémoire à semiconducteurs suivant la revendication 1, caractérisée par le fait que la région reliée à la ligne de bits est reliée avec une région supplémentaire (16) dont le dopage est opposé au dopage de base.

3. Cellule de mémoire à semiconducteurs suivant la revendication 2, caractérisée par le fait que la région supplémentaire (16) de dopage opposé est reliée à une zone semiconductrice en forme de bandes, dopée de façon opposée, prévue dans le corps semiconducteur (1) et servant de ligne de bits.

4. Cellule de mémoire à semiconducteurs suivant la revendication 2, caractérisée par le fait que la région semiconductrice supplémentaire (16) de dopage opposé est en contact, dans la région d'un trou de contact (17) de la première couche isolante du point de vue électrique (2), avec un revêtement (18) conducteur du point de vue électrique qui est relié de son côté à une ligne de bits.

5. Cellule de mémoire à semiconducteurs suivant la revendication 4, caractérisée par le fait que la ligne de bits se présente sous la forme d'une voie conductrice métallique (7), qui est placée sur une couche isolante (19) qui recouvre le revêtement.(18) conducteur du point de vue électrique, et qui est en contact avec le revêtement (18) conducteur du point électrique dans la région d'un autre trou de contact (20).

6. Cellule de mémoire à semiconducteurs suivant l'une des revendications précédentes, caractérisée par le fait que le corps semiconducteur (1) est muni d'une borne (1b) se trouvant à une tension fixe, et que l'électrode (8) du condensateur de mémorisation est reliée à une tension constante par l'intermédiaire d'une borne (8a).

7. Cellule de mémoire à semiconducteurs suivant l'une des revendications précédentes, caractérisée par le fait que le corps semiconducteur (1) est constitué par du silicium dopé, et que la porte de transfert (6) et/ou l'électrode (8) du condensateur de mémorisation et/ou le revêtement (18) établissant le contact avec la région supplémentaire (16) sont formés par du silicium polycristallin fortement dopé.

8. Procédé pour fabriquer une cellule de mémoire à semiconducteurs suivant la revendication 1, caractérisé par le fait qu'un corps semiconducteur (1) possédant un dopage de base est muni d'une zone de dopage (15) voisine de sa surface limite (1a), qui possède un dopage opposé au dopage de base, que la surface limite (1a) est recouverte d'une première couche isolante du point de vue électrique, qui possède une région de couche mince (2) se trouvant au-dessus de la zone de dopage et une région de couche épaisse (3) entourant la région de couche mince, que la porte de transfert (6) est placée sur la première couche isolante du point de vue électrique (2, 3), qu'on prévoit un premier masque qui laisse à découvert la porte de transfert (6), la région (5) reliée à la ligne de bits et le domaine du condensateur de mémorisation, qu'on effectue une première opération de dopage avec une substance dopante correspondant au dopage de base, qui produit les autres zones qui se trouvent sous ladite région (5) et la première zone (9), qu'on poursuit par une seconde opération de dopage avec une substance de dopage qui produit un dopage opposé au dopage de base, et qui forme la région (5) reliée à la ligne de bits et ladite première zone (9), ces deux opérations de dopage étant adaptées l'une à l'autre de manière qu'il apparaisse, sous la porte de transfert (6), des domaines marginaux des autres zones qui s'étendent jusqu'à la surface limite (1a) et qui délimitent ladite région (5) et la première zone (9) dans la direction latérale, qu'après élimination du premier masque, la porte de transfert (6) est recouverte d'une seconde couche isolante du point de vue électrique (10), et que l'électrode (8) du condensateur de mémorisation est placée sur la seconde couche isolante du point de vue électrique (10) et sur les parties de la première couche isolante du point de vue électrique (2) qui n'ont pas été remplacées par la seconde couche, de sorte qu'elle recouvre marginalement la porte de transfert (6).

9. Procédé suivant la revendication 8 pour fabriquer une cellule de mémoire à semiconducteurs suivant la revendication 2, caractérisé par le fait que la région supplémentaire (16) dopée de façon opposée est définie au moyen d'opérations photolithographiques, et est prévue au niveau de la surface limite (1a) du corps semiconducteur (1) de manière à être reliée à la région (5) couplée à la ligne de bits.

10. Procédé suivant la revendication 9, caractérisé par le fait qu'outre l'électrode (8), un revêtement conducteur (18), établissant un contact avec la région supplémentaire (16), est également placé sur la seconde couche (10) isolante du point de vue électrique et sur les parties de la première couche (2) isolante du point de vue électrique qui ne sont pas remplacées par la seconde couche, que le revêtement (18) établissant le contact est recouvert d'une autre couche (19) isolante du point de vue électrique, et que sur cette dernière est placée une voie conductrice (7) qui établit le contact de son côté avec le revêtement (18) d'établissement de contact, à l'intérieur d'un trou de contact (20) prévu dans l'autre couche (19) isolante du point de vue électrique.

11. Procédé suivant la revendication 8, caractérisé par le fait que la porte de transfert (6) est munie d'arêtes obliques et que les deux phases de dopage sont constituées par des phases d'implantation d'ions.

12. Procédé suivant la revendication 8, caractérisé par le fait que les deux phases de dopage sont constituées par des phases de diffusion.